Europäisches Patentamt

European Patent Office

Office européen des brevets

(11) Numéro de publication : **0 336 461 B1**

(12) **FASCICULE DE BREVET EUROPEEN**

(19)

(45) Date de publication du fascicule du brevet :
**12.10.94 Bulletin 94/41**

(51) Int. Cl.⁵ : **H01L 21/31**

(21) Numéro de dépôt : **89200402.9**

(22) Date de dépôt : **20.02.89**

(54) **Procédé pour aplanir la surface d'un dispositif semiconducteur.**

(30) Priorité : **26.02.88 FR 8802375**

(43) Date de publication de la demande :
**11.10.89 Bulletin 89/41**

(45) Mention de la délivrance du brevet :
**12.10.94 Bulletin 94/41**

(84) Etats contractants désignés :
**DE FR GB IT NL**

(56) Documents cités :
**EP-A- 0 151 948
EP-A- 0 216 425
EP-A- 0 243 273
FR-A- 2 599 892**

(73) Titulaire : **N.V. Philips' Gloeilampenfabrieken
Groenewoudseweg 1
NL-5621 BA Eindhoven (NL)**

(72) Inventeur : **De Bruin, Leendert
c/o INT. OCTROOIBUREAU B.V.
Prof. Holstlaan 6
NL-5656 AA Eindhoven (NL)**
Inventeur : **Van Laarhoven, Josephus
c/o INT. OCTROOIBUREAU B.V.
Prof. Holstlaan 6
NL-5656 AA Eindhoven (NL)**

(74) Mandataire : **Pinchon, Pierre et al
Société Civile S.P.I.D.
156, Boulevard Haussmann
F-75008 Paris (FR)**

**Description**

La présente invention concerne un procédé pour aplanir la surface d'un dispositif semiconducteur recouvert d'une couche diélectrique à base de verre de silice consistant à :
- déposer une couche de laque d'épaisseur suffisante pour obtenir une surface libre sensiblement plane après traitement convenable.
- opérer une attaque par plasma en étapes, laissant après décapage de la couche de laque une nouvelle surface libre de la couche diélectrique sensiblement plane.

L'évolution de la technique des dispositifs semiconducteurs indique une tendance générale vers une intégration de plus en plus poussée d'un grand nombre de composants au sein des circuits monolithiques. Au cours de leur fabrication, il est bien connu que des difficultés importantes sont entraînées par un manque de planéité de la surface de sorte que les opérations nécessaires pour niveler celle-ci font maintenant partie du processus normal d'élaboration des circuits intégrés et plus particulièrement si ceux-ci font appel à des structures à dimensions latérales très petites et une prise de contacts à plusieurs niveaux de métallisation.

Un procédé pour aplanir la surface d'un dispositif semiconducteur du genre indiqué en préambule est connu du document EP-A-0 243 273.

On indique en particulier dans ce document que lors d'une étape préliminaire de l'attaque durant laquelle le seul matériau de la couche de laque est décapé, on est libre de choisir des conditions d'attaque accélérée et notamment une concentration importante en oxygène dans le gaz d'alimentation du plasma. Par contre, dès lors que l'interface entre la couche de laque et le sommet de la couche diélectrique est atteint, il est prévu selon le procédé connu, d'utiliser alors une concentration réduite d'oxygène telle que dans ces conditions, une couche diélectrique homogène serait décapée à vitesse plus élevée qu'une couche de laque homogène. Les vitesses de décapage dont on vient de faire état sont celles qui sont observées lors d'expériences séparées dans lesquelles on attaque soit du diélectrique seul soit de la laque seule. Dans le procédé pratique où les deux matériaux sont attaqués simultanément, il se produit un équilibrage des vitesses d'attaque attribué à la libération d'espèces oxydantes provenant des portions de couche diélectrique attaquées et qui, activées par la plasma, contribuent à accroître la vitesse de décapage de la laque sans modifier sensiblement la vitesse de décapage du diélectrique.

Le procédé connu se réfère à un cas où la surface originelle de la couche diélectrique présente un relief à seulement deux niveaux de hauteur comme cela résulte typiquement de la réalisation d'une configuration métallique de contact sur une surface plane. La surface libre de la couche diélectrique formée sur une telle structure présente d'une part des portions proéminentes qui correspondent à l'emplacement de la configuration de contact, et d'autre part, des portions plus basses que les précédentes, en dehors de ladite configuration, la différence de hauteur entre ces deux portions de surface étant équivalente à l'épaisseur de la couche métallique de contact.

Il est toutefois souhaitable de pouvoir également rendre plane la surface d'un dispositif semiconducteur comportant un relief topographique à plus de deux niveaux de hauteur. Un tel relief apparaît par exemple au cours de la fabrication d'un circuit à transistors MOS à très haute densité d'intégration dans lequel on utilise un isolement par oxyde de champ qui est surélevé par rapport aux régions non isolées, et des portions d'une couche polycristalline dopée pour réaliser d'une part les électrodes de grille et d'autre part certaines liaisons électriques entre des zones actives, cheminant notamment au dessus de l'oxyde de champ. On aboutit alors à un relief à quatre niveaux différents de hauteur.

L'expérience a montré que le procédé connu était inapplicable au cas d'un relief à plus de deux niveaux distincts. Dans la majorité des essais effectués on a observé que le relief le plus profond c'est-à-dire la différence de hauteur qui sépare les deux niveaux les plus bas de la surface de la couche diélectrique, ne se trouvait pas atténué à l'issue de l'opération.

L'invention vise donc à fournir un perfectionnement au procédé connu tel que l'on puisse obtenir une bonne planéité à la surface d'un dispositif semiconducteur dont le relief topographique de départ est complexe.

En effet, selon la présente invention, un procédé pour aplanir la surface d'un dispositif semiconducteur est caractérisé par les moyens définis à la revendication 1.

Le procédé selon l'invention a l'avantage de rester simple puisque durant l'attaque simultanée des matériaux différents - diélectrique et laque -, il n'utilise que deux étapes durant lesquelles les conditions d'attaque sont sélectionnées à des valeurs déterminées différentes. Ces deux étapes font suite à une étape préliminaire au cours de laquelle la laque seulement est décapée. Il est clair que les conditions d'attaque utilisées pendant cette étape préliminaire peuvent être choisies librement puisque ces conditions sont sans effet sur la planéité finale. On peut donc, si on désire réduire la durée de l'opération d'attaque par plasma, utiliser au cours de l'étape préliminaire des conditions d'attaque accélérée de la laque, qui sont connues en soi. Dans ce cas, l'opération d'attaque utilise successivement trois séries de conditions différentes. On peut également utiliser les mêmes conditions d'attaque durant l'étape préliminaire et l'étape appelée première étape, ce qui réduit à deux seulement, le nombre des conditions différentes à appliquer durant le processus de décapage.

Il a été observé que dans un dispositif où la surface de la couche diélectrique présente un relief à plus de deux niveaux différents, le cas où un niveau intermédiaire entre les niveaux extrêmes s'étend sur une fraction majoritaire de l'aire totale du dispositif est le cas le plus fréquent en pratique. Par fraction majoritaire, on entend ici une fraction qui dépasse 50% de l'aire totale.

Le procédé selon l'invention s'applique à un tel cas de dispositif semiconducteur en fournissant un moyen précis pour déterminer l'instant où la première étape de l'attaque par plasma doit être interrompue et les conditions doivent alors être modifiées en vue de procéder à la deuxième étape de l'attaque. En effet, l'observation de la raie d'émission lumineuse de CO produite par le plasma au cours de la première étape du décapage révèle une augmentation brusque d'intensité qui correspond sensiblement au moment où le niveau principal de la surface de la couche diélectrique est en train de se découvrir de laque.

L'interruption de la première étape est alors effectuée soit au moment où l'augmentation d'intensité de la raie de CO passe pas son maximum, soit après un court délai prédéterminé, au delà de ce maximum, ceci en fonction des particularités du relief topographique du substrat en cours de traitement. L'instant où la première étape de décapage doit être interrompue peut donc être déterminé de façon reproductible, d'une opération de décapage à l'autre, pour une série de substrats ayant des caractéristiques voisines.

Il est possible de déterminer à l'avance quelles sont les conditions de décapage à appliquer durant chacune des deux étapes: durant la première étape, les conditions d'attaque sont choisies pour produire une vitesse d'attaque du diélectrique qui soit de 1 à 1,5 fois la vitesse d'attaque de la laque ces vitesses étant mesurées lors d'une attaque simultanée des deux matériaux dont la proportion de surfaces exposées est équivalente à celle du début de cette étape où les seules portions les plus proéminentes de la couche diélectrique sont découvertes, alors que durant la deuxième étape, les conditions d'attaque sont modifiées pour produire une vitesse d'attaque du diélectrique qui soit de 1 à 1,5 fois la vitesse d'attaque de la laque, ces vitesses étant mesurées lors d'une attaque simultanée de ces mêmes matériaux, mais avec une proportion de surfaces exposées qui est équivalente à celle d'un stade final de l'attaque où les seules portions de la surface de la couche diélectrique qui sont plus profondes que ledit niveau principal sont encore couvertes de laque.

Pour un relief topographique donné, une caractéristique pratique intéressante est représentée par la comparaison entre le volume moyen des protubérances et le volume moyen des dépressions par référence audit niveau principal du relief.

Dans la mesure où ces volumes sont sensiblement équivalents, ce qui apparaît être fréquemment le cas en pratique, l'interruption de la première étape est effectuée à l'instant repéré par la brusque augmentation de l'intensité d'émission de la raie de CO et non pas après un certain délai suivant cet instant.

La description qui va suivre en regard des dessins annexés, le tout donné à titre d'exemple non limitatif, fera bien comprendre comment l'invention peut être réalisée.

Les figures 1A et 1B représentent schématiquement des vues partielles et en coupe d'un exemple de dispositif, respectivement au début et en cours de réalisation du procédé selon l'invention.

La figure 2 présente un diagramme de l'aire occupée par la couche diélectrique relativement à l'aire totale en fonction d'un niveau de profondeur croissant, correspondant à l'exemple du dispositif de la figure 1A.

La figure 3 représente en fonction du temps, la variation de l'intensité lumineuse de la raie de CO émise par le plasma durant une attaque à conditions fixes d'une structure telle que celle de la figure 1A.

La figure 4 donne une courbe de variation de la vitesse de décapage d'une couche de laque dans des conditions opératoires identiques, mais sur des échantillons présentant diverses proportions de surface découvertes du diélectrique.

La figure 5 représente le rapport de la vitesse de décapage du diélectrique à la vitesse de décapage de la laque en fonction du débit d'oxygène alimentant le plasma, pour deux valeurs de la proportion de surface découverte du diélectrique.

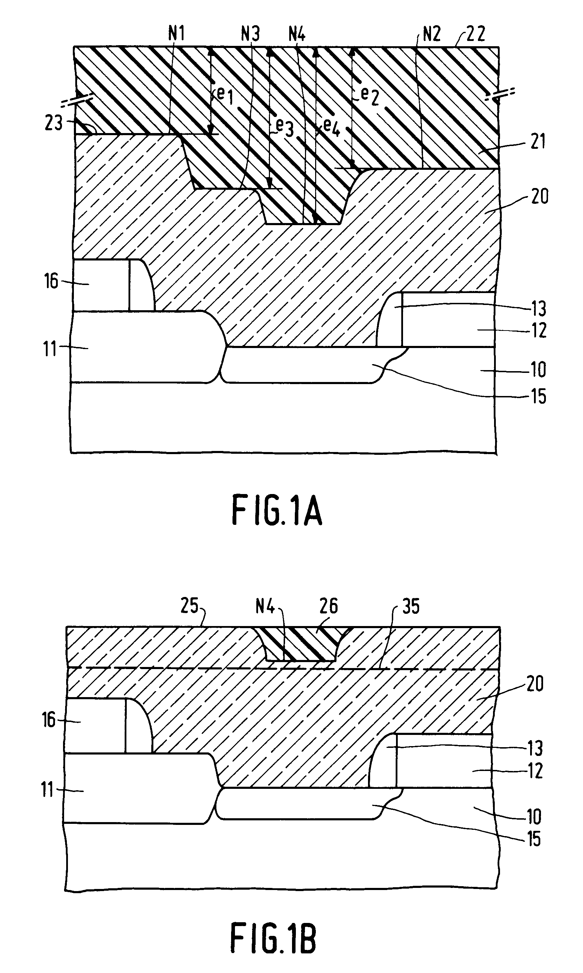

La figure 1A est relative à un dispositif intégré à transistors MOS représenté de manière partielle et très schématique. Un substrat 10 en silicium est partiellement recouvert d'une couche d'oxyde de champ 11 servant à délimiter des régions actives notamment des transistors. Chaque transistor présente une électrode de grille 12 conductrice, réalisée à partir d'une couche de silicium polycristallin relativement épaisse, découpée à la configuration nécessaire. Ainsi qu'il est connu et couramment pratiqué dans le domaine des circuits intégrés, à très haute densité d'intégration, la grille 12 est bordée par un cordon latéral isolant 13 de manière à faciliter la prise de contact sur les régions de source et de drain 15 de manière autoalignée. On a représenté également sur la figure une ligne de liaison électrique 16, réalisée simultanément avec les grilles 12 des transistors, qui se trouve au moins partiellement isolée du substrat 10 par le fait qu'elle est positionnée sur l'oxyde de champ 11. Le dispositif semiconducteur a été recouvert d'une couche diélectrique 20 relativement épaisse, à base de verre de silice.

Pour le dépôt de cette couche diélectrique 20 on a utilisé un procédé ayant des propriétés de bon recouvrement de surface y compris les surfaces non horizontales, comme par exemple la méthode dite de dépôt chimique en phase vapeur (CVD) à pression atmosphérique, ou à basse pression (LPCVD), ou encore une méthode de dépôt chimique activée par plasma. La surface de la couche diélectrique 20 n'est pas plane, et présente au contraire un relief que le procédé selon l'invention a pour objet d'aplanir.

A cet effet, on a déposé sur l'ensemble du dispositif une couche de laque 21 connue pour ses propriétés de réduction du relief de surface, soit par exemple, la laque photosensible vendue par la Société "HUNT CHEMICAL" sous la référence commerciale HPR204. On choisit en général de déposer la couche de laque 21 avec une épaisseur relativement importante, par exemple de 1200 nm de manière à obtenir un effacement pratiquement total du relief à la surface libre 22 de ladite couche de laque 21, à l'issue d'un traitement consistant en une exposition de 45 secondes à la lumière ultra-violette suivie d'une cuisson à 200°.

La figure 1A représente donc une partie du dispositif semiconducteur à ce stade du procédé. Il est à noter cependant que sur cette figure, certains détails comme la couche d'oxyde de grille ou les métallisations de source et de drain n'ont pas été représentés ces détails étant pratiquement sans rapport avec l'invention.

En vue d'aplanir la surface de la couche diélectrique 20 on soumet le dispositif muni de la couche de laque 21 à une attaque progressive à partir de la surface libre 22 par l'action d'espèces gazeuses ionisées créées par un plasma.

On a utilisé à cet effet un mélange gazeux contenant un composé fluorocarbone et de l'oxygène sous une pression de 180Pa, activé par un champ électrique radiofréquence à 400KHz, d'une puissance de 3,7 W/cm² de substrat.

Selon un procédé connu, il est possible de réduire la durée de l'attaque lorsque, durant une phase préliminaire, on utilise une concentration élevée en oxygène dans les gaz alimentant le plasma et ceci tant que l'attaque est produite exclusivement sur la laque et que la couche diélectrique n'a été découverte en aucune de ces parties. Lorsque les portions les plus proéminentes de la couche diélectrique 20 (telles que la portion 23) sont découvertes, la phase préliminaire d'attaque est terminée et il faut alors utiliser des conditions d'attaque telles que le matériau de la couche diélectrique et la laque soient attaquées à des vitesses très sensiblement égales.

Selon le procédé connu, l'attaque est alors poursuivie simultanément sur les deux matériaux - diélectrique et laque - en utilisant une alimentation en gaz du plasma dont la proportion d'oxygène par rapport au composé fluorocarbone est réduite par rapport à la proportion particulière qui produit une égalité des vitesses d'attaque lorsque chacun de ces matériaux est attaqué en l'absence de l'autre. Toutefois, dans le cas d'un dispositif tel que celui cité en exemple, dont le relief est à plus de deux niveaux différents, il n'a pas été possible avec le procédé donnu, d'obtenir une surface finale de couche diélectrique qui soit plane. Dans l'exemple cité, qui est représenté figure 1A la surface originelle de la couche diélectrique comporte quatre niveaux différents, le niveau N1 correspondant au relief introduit par la ligne de liaison 16, le niveau N2 correspondant au relief introduit par la grille 12 des transistors, le niveau N3 correspondant au relief introduit par la couche d'oxyde de champ 11 et enfin le niveau N4 correspondant aux zones actives à la surface du corps semiconducteur.

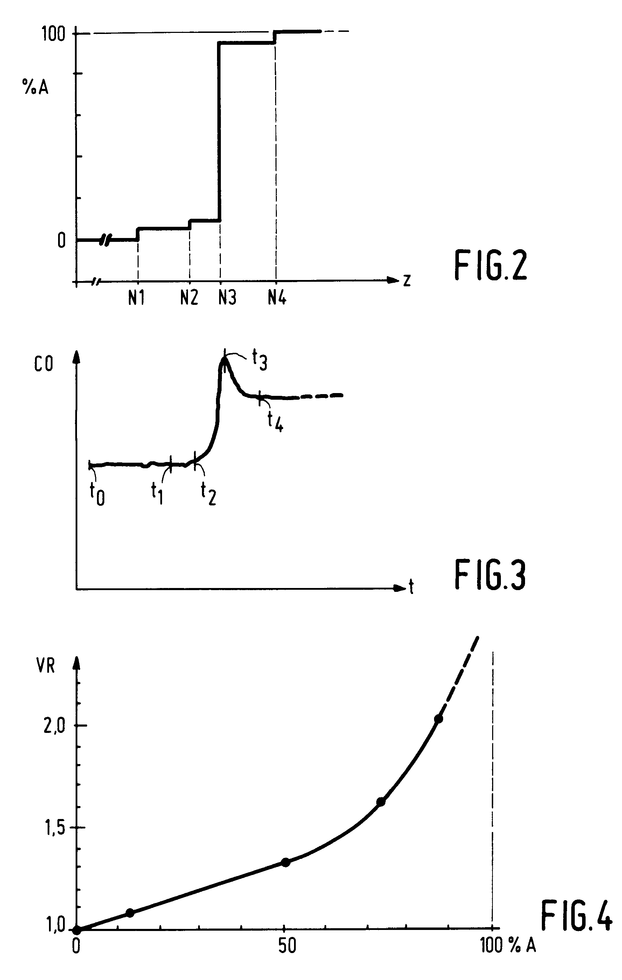

On peut observer en pratique que dans certaines régions du dispositif la structure est répétitive sous forme de cellules identiques accolées les unes aux autres à courte distance. On peut définir dans ces régions la proportion d'aire occupée par les niveaux N1 à N4 par rapport à l'aire totale de ces régions. La figure 2 représente un diagramme des aires relatives cumulées qui sont découvertes lorsque l'on franchit successivement les niveaux N1, N2, N3, N4, c'est-à-dire en fonction de la prodondeur z de pénétration dans la couche diélectrique. Ce diagramme qui correspond au dispositif pris comme exemple à la figure 1A, présente une particularité typique et fréquente en pratique qui correspond au fait que l'un des niveaux compris entre les niveaux extrêmes N1 et N4 occupe une fraction majoritaire de l'aire totale, ici le niveau N3, qui pour cette raison sera appelé "niveau principal".

En utilisant le procédé connu, il est relativement aisé d'obtenir une surface aplanie de la couche diélectrique jusqu'au niveau principal N3 alors que le relief représenté par la différence de niveau entre le niveau N3 et le niveau N4 n'est pratiquement pas atténué.

Aussi, selon l'invention, l'attaque simultanée des deux matériaux est effectuée en deux étapes : une première étape durant laquelle, dans l'alimentation en gaz du plasma, la proportion d'oxygène par rapport au composé fluorocarbone est plus élevée que durant la deuxième étape. L'invention propose également de déterminer le moment où il est nécessaire d'interrompre la première étape, par l'observation de la raie d'émission de CO produite par le plasma.

La figure 3 représente un diagramme en fonction du temps t de l'intensité d'émission de la raie de CO, située à 482,7nm de longueur d'onde, selon une échelle arbitraire, au cours d'une opération d'attaque durant laquelle l'alimentation en gaz du plasma et en particulier la concentration d'oxygène par rapport au composé fluorocarbone a été maintenue constante durant toute l'opération. L'intervalle de temps compris entre t0 et t1 correspond à l'attaque de la laque seule, c'est-à-dire à la phase préliminaire, tandis que la partie de courbe qui se présente au-delà de l'instant t4 correspond à la découverte totale de la couche diélectrique et à l'attaque de ce seul matériau. Entre les instants t1 et t4 la courbe de variation d'intensité d'émission présente une élévation brusque d'intensité avec un maximum très net repéré à l'instant t3. Ainsi qu'il sera expliqué par la suite, l'instant t3 correspond très sensiblement au moment où le niveau principal N3 se trouve découvert de laque au cours de l'attaque. Les instants repérés par t1 et t2 correspondent aux moments où sont franchis respectivement les niveaux N1 et N2 de la surface de la couche diélectrique. Comme les proportions d'aire découvertes aux niveaux N1 et N2 sont faibles comparativement à l'aire totale ou comparativement à l'aire découverte au niveau principal N3, de même les variations d'intensité d'émission de la raie de CO telles qu'elles sont observées sur la courbe de la figure 3 restent également faibles.

On a procédé à une série d'expériences dans lesquelles les conditions d'alimentation en gaz du plasma étaient identiques à savoir :
débit de tétrafluorométhane CF4 = 70 cm³/min
débit d'argon = 650 cm³/min
débit d'oxygène = 13 cm³/min
puissance d'excitation du plasma = 3,7 W/cm² de substrat,
pression maintenue à environ 185 Pa
et en décapant successivement des substrats présentant simultanément des portions de couche de laque et des portions de couche diélectrique dans des proportions déterminées qui étaient différentes au cours de chaque expérience.

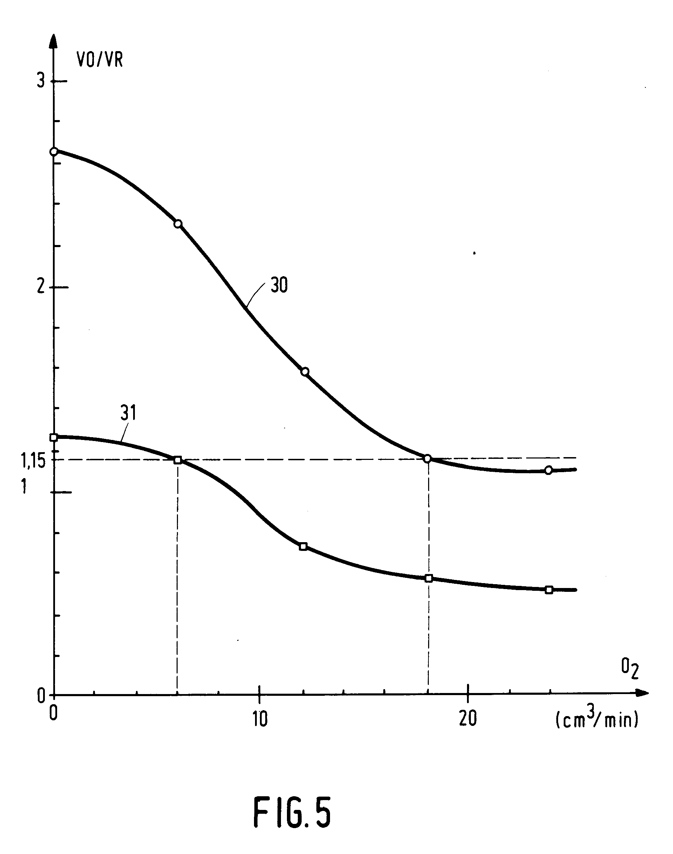

La figure 4 représente les différentes valeurs obtenues de la vitesse de décapage de la laque VR en fonction de l'aire relative A de couche diélectrique décapée simultanément pendant la même opération. Sur la courbe, la vitesse de décapage VR est représentée en échelle relative, la valeur 1 étant donnée à la vitesse obtenue lorsque le seul matériau de laque est décapé, c'est-à-dire en l'absence de diélectrique. Comme on peut le constater sur cette figure, la vitesse de décapage de la laque varie considérablement en fonction de la proportion de surface du matériau diélectrique qui est décapé simultanément. Au cours des mêmes expériences la vitesse de décapage du matériau de la couche diélectrique reste sensiblement constante. On attribue ceci au fait que l'oxygène libéré par l'attaque de la couche diélectrique peut être au moins partiellement remis en jeu dans le plasma et contribue ainsi au décapage de la laque qui est soumise simultanément à la même opération. Le décapage de la couche diélectrique quant à lui dépend principalement de la quantité d'ions fluor mise en jeu pendant l'attaque et reste relativement insensible à la concentration en oxygène ce qui explique l'absence de variation notable de la vitesse de décapage du diélectrique lors de ces expériences.

Il est à noter que des résultats pratiquement identiques à ceux indiqués à la figure 4 sont également obtenus lorsque le débit de $CF_4$ est réduit à 52cm³/min et qu'on y ajoute un débit de 18cm³/min de $CHF_3$, le débit d'oxygène étant alors porté à 18cm³/min.

On peut tenter d'expliquer qualitativement la forme de la courbe expérimentale de la figure 3. Entre les instants t0 et t1, c'est-à-dire pendant l'attaque du seul matériau de la laque, la quantité de CO produite par l'attaque est limitée à une valeur constante correspondant à la concentration, de l'oxygène dans les gaz de réaction qui est faible. Au contraire, au-delà de l'instant t4 c'est-à-dire lorsque le seul matériau de la couche diélectrique est décapé, la quantité de CO produite par unité de temps est limitée par la concentration d'atomes de carbone contenue dans les gaz d'alimentation du plasma alors qu'au débit d'oxygène introduit s'ajoute l'oxygène produit par l'attaque de la couche diélectrique. Lorsque le niveau principal N3 se découvre de laque pendant l'attaque, il se produit simultanément une augmentation très rapide de la surface de diélectrique découverte et une diminution correspondante de la surface de laque soumise à l'attaque. Au cours de cette variation rapide de la proportion de surfaces occupées par les deux matériaux, on dispose pendant un court instant d'une part d'une surface relativement importante de diélectrique produisant par son attaque un dégagement important d'oxygène et en même temps d'une surface relativement importante de laque libérant par attaque des atomes de carbone. On peut expliquer ainsi que la raie d'émission de CO passe par un maximum d'intensité au moment où le niveau principal N3 se découvre de laque pendant l'attaque.

Un raisonnement simple permet également d'expliquer de manière semi-quantitative la raison pour laquelle l'instant t3 auquel se produit le maximum d'intensité d'émission de la raie de CO correspond à très peu près au moment où les surfaces planes de grande étendue sont également découvertes par la laque. A la surface du substrat, certaines régions, comme les plages de contact ou les chemins de découpe, présentent une surface plane dépourvue de relief. La méthode utilisée pour déposer la laque procure en ces régions une épaisseur que l'on appelera épaisseur nominale de couche $e_{nom}$. Dans les autres régions du substrat, qui présentent un relief à différents niveaux se répétant périodiquement à courte distance on admettra que le volume moyen de laque déposé par unité de surface équivaut à l'épaisseur nominale de couche.

Appelons $e_1$, $e_2$, $e_3$ et $e_4$ (voir figure 1), les épaisseurs de la couche de laque 21 à l'aplomb des niveaux respectifs $N_1$, $N_2$, $N_3$, $N_4$ de la couche diélectrique, et $s_1$, $s_2$, $s_3$ et $s_4$ les proportions d'aire présentées par ces niveaux telles que $s_1+s_2+s_3+s_4 = 1$. On peut alors écrire :

$$e_1.s_1 + e_2.s_2 + e_3.s_3 + e_4.s_4 = e_{nom} \quad (1)$$

Cette relation peut être réécrite par référence à l'épaisseur de laque $e_3$ couvrant le niveau principal $N_3$ :

$$e_3.(s_1 + s_2 + s_3 + s_4) + (e_1 - e_3).s_1 + (e_2 - e_3).s_2 + (e_4 - e_3).s_4 = e_{nom} \quad (2)$$

soit encore :

$$e_3 = e_{nom} + (e_3 - e_1).s_1 + (e_3 - e_2).s_2 - (e_4 - e_3).s_4 \quad (3)$$

La relation (3) exprime que l'épaisseur $e_3$ de la couche de laque à l'aplomb du niveau principal N3 de la couche diélectrique est égale à l'épaisseur nominale $e_{nom}$ de la couche de laque à l'aplomb des étendues planes de dimensions importantes dans la mesure où le volume des portions du diélectrique qui dépassent le niveau principal N3 équivaut en moyenne le volume des portions manquantes du diélectrique en dessous du niveau principal N3.

Du fait même que par hypothèse le niveau principal N3 occupe une proportion d'aire $s_3$ importante par rapport aux autres, ce qui se vérifie très souvent en pratique, l'épaisseur de laque $e_3$ couvrant le niveau principal $N_3$ reste très voisin de l'épaisseur nominale $e_{nom}$. Dans le cas ayant servi d'exemple jusqu'ici, l'application numérique de la relation (3) aboutit à :

$$e_3 = e_{nom} + 7nm,$$

c'est-à-dire $e_3$ voisin de $e_{nom}$.

Ainsi, le niveau principal N3 du relief et les régions planes de dimensions importantes se trouvent découvertes de laque presque simumtanément au cours du décapage. D'une part ceci a pour conséquence de rendre très nette l'augmentation d'intensité du pic d'émission de la raie de CO durant le décapage. D'autre part, l'invention met à profit cette propriété pour déterminer précisément à quel instant la première phase de l'attaque doit être interrompue.

Dans la plupart des cas pratiques, l'écart entre l'épaisseur $e_3$ de la couche de laque à l'aplomb du niveau principal N3, et l'épaisseur $e_{nom}$, à l'aplomb des régions planes de dimensions importantes est très faible et peut être négligé. L'interruption de la première phase d'attaque est alors effectuée au même instant où la raie d'émission de CO présente son augmentation brusque d'intensité (instant $t_3$).

Dans d'autres cas où, par application de la relation (3), il apparait que $e_3 > e_{nom}$ avec un écart d'épaisseur qui est significatif, on peut choisir d'interrompre la première phase de l'attaque à la suite d'un court délai après l'augmentation d'intensité d'émission de la raie de CO, délai dont la durée peut être facilement déterminée par expérience.

La première étape de décapage est donc interrompue en coupant la puissance du générateur radio-fréquence. Les conditions d'alimentation en gaz du réacteur de décapage sont alors modifiées et en particulier la proportion d'oxygène par rapport au composé fluorocarbone est réduite de manière à produire une vitesse d'attaque du diélectrique qui soit de 1 à 1,5 fois la vitesse d'attaque de la laque dans les conditions réelles de la deuxième étape c'est-à-dire avec la proportion de surface de couche diélectrique qui est alors exposée. Les débits de gaz introduits dans le réacteur d'attaque correspondant aux conditions d'attaque modifiées en vue de la deuxième phase de l'attaque sont stabilisées pendant une courte période en l'absence de la puissance radio-fréquence.

Le dispositif semiconducteur pris en exemple dans la description de la figure 1A, se trouve alors dans un état tel que représenté à la figure 1B. Sur ces deux figures les éléments correspondants sont affectés des mêmes repères numériques. La couche diélectrique 20 qui a été attaquée pendant la première étape présente maintenant une nouvelle surface libre 25 qui est sensiblement plane et qui correspond pratiquement au niveau principal N3 de la figure 1A.

Seul le niveau le plus profond N4 de la couche diélectrique 20 se trouve encore recouvert par une portion résiduelle 26 de la couche de laque.

On se reporte maintenant aux courbes de la figure 5 pour montrer comment sont déterminées les conditions d'attaque durant la première étape et durant la deuxième étape du procédé selon l'invention. Ces courbes représentées ont été obtenues par une série d'expériences dans lesquelles le débit de tétrafluorométhane $CF_4$ était de 52 $cm^3$/min auquel était ajouté un débit de trifluorométhane $CHF_3$ de 18 $cm^3$/min la pression était maintenue à 185 Pa et la puissance d'excitation du plasma à 3,7 $W/cm^2$. Les courbes 30 et 31 de la figure 5 présentent le rapport VO/VR de la vitesse d'attaque de la couche diélectrique VO par rapport à la vitesse d'attaque de la laque VR en fonction de divers débits d'oxygène introduits dans les gaz d'alimentation du plasma.

La courbe 30 est relative à des échantillons similaires présentant une proportion de surface de diélectrique exposée de 7% tandis que la courbe 31 correspond à une autre série d'échantillons similaires pour lesquels la proportion de surface de couche diélectrique exposée était voisine de 90%. Avec un échantillon du type de celui décrit en exemple aux figures 1 et 2 dont les parties les plus proéminentes de la couche diélectrique c'est-à-dire les parties de niveau N1 représentent une proportion de surface de l'ordre de 7%, un débit d'oxygène de 18$cm^3$/min a été utilisé durant la première phase de l'attaque donnant un rapport VO/VR de 1,15 dans des conditions qui sont celles indiquées par ailleurs à propos de la figure 5. De préférence, on choisit avantageusement un rapport VO/VR compris entre 1 et 1,5.

Durant la deuxième étape d'attaque, où seules les portions de la surface de la couche diélectrique 20 qui sont plus profondes que le niveau principal N3 sont encore recouvertes de laque alors que la proportion de surface de la couche diélectrique découverte est alors voisine de 90%, un débit d'oxygène de 6$cm^3$/min a été choisi pour alimenter le plasma ce qui donne un rapport VO/VR de 1,15 comme indiqué à la figure 5. Dans cette phase encore, on choisit avantageusement un rapport VO/VR qui soit compris entre 1 et 1,5.

Il a été observé expérimentalement que lors du décapage, si on remplace une certaine fraction du débit de tétrafluorométhane CF$_4$ par un débit équivalent de trifluorométhane CHF$_3$ pour l'alimentation en gaz du plasma il est alors nécessaire d'augmenter quelque peu le débit d'oxygène pour obtenir le même résultat c'est-à-dire par exemple un rapport VO/VR=1. L'introduction d'une proportion de trifluorométhane avec le tétrafluorométhane est donc avantageuse pour que le débit d'oxygène à utiliser pendant la deuxième étape de l'attaque reste positif ou nul. La figure 5 montre en effet qu'il est toujours nécessaire de réduire la proportion d'oxygène par rapport au composé fluorocarbone au cours de la deuxième étape par rapport au débit utilisé pendant la première étape, de manière à conserver au cours de chacune de ces étapes une vitesse d'attaque du diélectrique qui soit comprise entre 1 et 1,5 fois la vitesse d'attaque de la laque.

La fin de la deuxième étape de l'attaque a lieu après que la couche diélectrique 20 ait eu sa surface totalement découverte de laque. Le moment où la deuxième étape doit être interrompue est fixé au moyen de l'une des techniques habituelles, comme par exemple, l'utilisation d'une durée précise d'opération, ou l'observation de l'une des raies du spectre d'émission du plasma, ou encore par interférométrie optique sur la partie restante de la couche diélectrique 20.

A l'issue du procédé, une nouvelle surface libre de couche diélectrique 20 est obtenue. Elle a été indiquée par la ligne en traits interrompus 35 à la figure 1B.

Cette nouvelle surface libre 35 est pratiquement exempte de relief lorsqu'on opère conformément à l'invention, les dénivellations résiduelles restant en général inférieures à 50 nm. On peut ensuite procéder aux opérations ayant pour but d'établir une configuration d'interconnexion à la surface du dispositif semiconducteur, la nouvelle surface libre 35 de la couche diélectrique 20 fournissant la base souhaitée, exempte de dénivellations abruptes, pour le dépôt d'une couche conductrice d'interconnexion.

Bien que l'invention ait été décrite au moyen d'exemples limités de réalisation, il reste entendu que des variantes, facilement imaginables par l'homme de l'art, sont possibles. En particulier, on a reporté à titre d'exemple des conditions préférées dans lesquelles on opère le décapage par plasma. Il est clair que ces conditions peuvent être modifiées dans une large mesure notamment en ce qui concerne les valeurs de la pression, de la puissance et de la fréquence du générateur radio-fréquence, valeurs qui sont généralement liées au type d'appareillage utilisé. Par ailleurs, à la place du tétrafluorométhane (CF$_4$) ou du mélange trétrafluorométhane-trifluorométhane (CF$_4$-CHF$_3$), mentionnés en tant que composé fluorocarbone, on peut encore utiliser le composé CHF$_3$ seul ou l'un des autres composés de la famille représentée par la formule générale C$_x$F$_y$ ou encore tout autre composé convenable riche en fluor.

## Revendications

1. Procédé pour aplanir la surface d'un dispositif semiconducteur recouvert d'une couche diélectrique à base de verre de silice, consistant à
   - déposer une couche de laque d'épaisseur suffisante pour obtenir une surface libre sensiblement plane après traitement convenable,
   - opérer une attaque par plasma en étapes, laissant après décapage de la couche de laque une nouvelle surface libre de la couche diélectrique sensiblement plane,

   procédé dans lequel on utilise une alimentation en gaz du plasma qui, lors de chaque étape, contient une proportion en oxygène d'autant plus réduite par rapport à un composé fluorocarbone de ce gaz que la proportion de l'aire du diélectrique découverte lors de cette étape est élevée, par rapport à l'aire totale du dispositif, dans lequel lorsque l'attaque est pratiquée sumultanément sur les deux matériaux : diélectrique et laque, la proportion d'oxygène par rapport au composé fluorocarbone est reduite par rapport à la proportion particulière qui produit une égalité des vitesses d'attaque lorsque chacun de ces matériaux est attaqué en l'absence de l'autre, et dans lequel une raie d'émission de CO produite par le plasma est observée pour renseigner sur le déroulement de l'attaque,

   caractérisé en ce que, en vue d'aplanir une couche diélectrique dont la surface originale présente un relief à plus de deux niveaux différents, on définit un niveau dit principal occupant une fraction majoritaire de l'aire totale du dispositif, lequel niveau étant compris entre les niveaux extrêmes, et en ce que l'attaque simultanée du diélectrique et de la laque est opérée uniquement en deux étapes, le moment pour effectuer le changement entre ces deux étapes étant défini par rapport à l'instant où la raie d'émission de CO présente une augmentation brusque d'intensité cet instant correspondant très sensiblement au moment où ledit niveau principal se trouve découvert de laque.

**Patentansprüche**

1. Verfahren zur Planarisierung der Oberfläche einer mit einer dielektrischen Schicht auf Quarzglasbasis bedeckten Halbleiteranordnung, bestehend aus:
    - einer Aufbringung einer Lackschicht mit ausreichender Dicke, um eine freie, nach geeigneter Behandlung im wesentlichen plane Oberfläche zu erhalten,
    - einer Durchführung einer schrittweisen Plasmaätzung zum Erhalt einer neuen, freien, im wesentlichen planen Oberfläche der dielektrischen Schicht nach Wegätzung der Lackschicht,

wobei bei dem Verfahren eine Zufuhr von Plasmagas verwendet wird, die bei jedem Verfahrensschritt einen Sauerstoffanteil enthält, der im Verhältnis zu einer Fluorkohlenstoffverbindung dieses Gases um so mehr reduziert wird, je höher der Oberflächenanteil des freigelegten Dielektrikums während dieses Verfahrensschrittes im Verhältnis zum Gesamtfläche der Anordnung ist, wobei während der gleichzeitig auf den beiden Materialien Dielektrikum und Lack durchgeführten Plasmaätzung der Sauerstoffanteil im Verhältnis zur Fluorkohlenstoffverbindung entsprechend dem speziellen Anteil reduziert wird, der eine Gleichheit der Ätzraten während der Ätzung jedes der beiden Materialien in Abwesenheit des anderen herbeiführt, und wobei eine vom Plasma erzeugte Emissionslinie von CO beobachtet wird, um den Verlauf der Ätzung zu verfolgen,

dadurch gekennzeichnet, daß hinsichtlich der Planarisierung einer dielektrischen Schicht, deren ursprüngliche Oberfläche ein Profil mit mehr als zwei verschiedenen Ebenen aufweist, eine als Hauptebene bezeichnete Ebene definiert wird, die einen größeren Teil der Gesamtfläche der Anordnung einnimmt, wobei die Ebene zwischen den äußeren Ebenen liegt, und daß die gleichzeitige Ätzung des Dielektrikums und des Lackes in nur zwei Schritten durchgeführt wird, wobei der Zeitpunkt für den Übergang zwischen diesen beiden Schritten anhand des Zeitpunkts definiert wird, zu dem die CO-Emissionslinie einen plötzlichen Intensitätsanstieg aufweist, wobei dieser Zeitpunkt sehr genau dem Zeitpunkt entspricht, zu dem die genannte Hauptebene vom Lack befreit ist.

**Claims**

1. A method of planarizing the surface of a semiconductor device covered with a dielectric layer on the basis of silica glass, which method comprises
    - deposition of a photoresist layer having a thickness sufficient to obtain a free, substantially flat surface after a suitable treatment;
    - plasma etching in steps so that after etching of the photoresist layer a new free surface of the dielectric layer is obtained, which is substantially flat,

in which method a supply of plasma gas is used which contains during each step a relative quantity of oxygen which is progressively reduced in comparison with a fluorocarbon component of this gas in proportion as the surface area of the dielectric exposed during this step is greater in comparison with the total surface area of the device, in which method, the etching being carried out simultaneously on the two materials: dielectric and photoresist, the relative quantity of oxygen in comparison with the fluorocarbon component is reduced relative to the particular relative quantity which produces equal etching rates for each of these materials if it were etched in the absence of the other one, and in which method a CO emission beam produced by the plasma is observed so as to give an indication on the progress of the plasma attack, characterized in that, for planarizing a dielectric layer whose initial surface exhibits a relief of more than two different levels, a so-called main level is defined which occupies a major proportion of the total surface area of the device, which level lies between the extreme levels, and in that the simultaneous etching of the dielectric and the photoresist is carried out in two steps only, the moment for switching from one step to the other being defined by reference to the moment the CO emission line shows a sudden increase in intensity, which moment corresponds closely to the moment at which said main level becomes uncovered from under the photoresist.

FIG.1A

FIG.1B

FIG.2

FIG.3

FIG.4

FIG.5